# EUROPEAN PATENT SPECIFICATION

(11) **EP 0 535 308 B1**
(45) Date of publication and mention of the grant of the patent: **01.03.1995**
(21) Application number: 92109299.5
(22) Date of filing: 02.06.1992
(51) Int. Cl.: C23C 16/44, C30B 25/14

(54) **Device for introducing reagents into an organometallic vapour phase deposition apparatus**
Vorrichtung zur Reagenzeinleitung in eine Vorrichtung für Metall-organische Abscheidung aus der Gasphase
Dispositif pour l'introduction de réactifs dans un dispositif de dépôt organométallique en phase vapeur

(30) Priority: 04.06.1991 IT TO910129 U
(43) Date of publication of application: 07.04.1993
(73) Proprietor: CSELT Centro Studi e Laboratori Telecomunicazioni S.p.A., I-10148 Turin (IT)
(72) Inventor: Bertone, Daniele, Torino (IT)
(74) Representative: Riederer Freiherr von Paar zu Schönau, Anton

(56) References cited:
- US-A- 4 747 367
- JOURNAL OF CRYSTAL GROWTH vol. 77, no. 1-3, September 1986, AMSTERDAM, THENETHERLANDS pages 73 - 78 R.S.SILLMON ET AL. 'AN ULTRA-FAST GAS DELIVERY SYSTEM FOR PRODUCING ABRUPT COMPOSITIONAL SWITCHING IN OMVPE

## Description

The present invention regards the plant for fabricating semiconductor devices and more particularly it concerns a device for introducing reagents into an apparatus for deposition from vapour phase organometallic materials.

As known, many electronic devices, and more particularly many optoelectronic devices used in optical fibre transmission systems, such as lasers, photodetectors, etc., consist of semiconducting material structures formed of various monocrystalline layers with different compositions within the Indium, Gallium, Arsenic and Phosphor system and with thicknesses comprised between fractions of a »m (micron) and a few »m (microns).

The individual layers are obtained by depositing appropriate compounds on a starting substrate using for the operation different methods, among which MOCVD (Metal-Organic Chemical Vapour Deposition) is widely used. According to this method the sources of metals, like Ga, In, consist of organometallic compounds, while the precursors of nonmetals, like As, P, consist of the corresponding hydrides.

During deposition, mixtures of the reagents above are transported by use of carrier gases, like H₂, Ar, in the reactor, wherein the starting substrate is present, kept at convenient temperature. As they arrive there, they react with each other, yielding the desired semiconducting material which is deposited on the substrate. To obtain different layers the flow of reagent with a certain composition is replaced by a flow of reagents with different composition, trying at the same time to keep all the other physical conditions unchanged, so as to avoid the formation of layers with uncontrolled composition.

According to the so-called vent/run method, described in the article entitled "An ultra-fast gas delivery system for producing abrupt compositional switching in OMVPE", written by R.S.Sillmon et alii, issued on pages 73-78 of the Journal of Crystal Growth, No.77, 1986, the gaseous flow in the line of each reagent is never halted, but it is only switched either towards the reactor (run line) or towards an exhaust line (vent line).

The changeover between the two directions is obtained by acting on valves, which by halting the reagent flow or by letting it through, allows the reagent to be routed towards the desired line, thus obtaining also the purging of manifolds prior to the immission of the new flow into the reactor. To obtain this, the valves are activated in opposite manner, i.e. when one is OFF, the other is ON.

In addition, because it is of main importance that the composition of each layer is constant and the transition from one layer to another is well defined, flow changeover in the reactor must take place as quickly as possible, so as to reduce to the minimum reagent stagnation in dead spaces of valves and manifolds, which for this reason must present low volumes (see e.g. US-A-4 747 367).

Reagent flow changeover can take place without abrupt pressure variation if pressures in vent and run lines are equal. Pressure balancing is usually obtained by an electronic control system using a differential manometer for measuring pressure differences and a flowmeter for adjusting carrier gas flow in an additional line. By this line, carrier gas is injected into the line at a lower pressure till pressure values are balanced again. However a certain delay in control system response cannot be avoided, especially if line volumes are not negligible.

Furthermore, in known vent/run system the reagent stagnation problem is not completely solved, since two valves joined with a pipe segment of non negligible length are usually used for the operation, owing to valve dimensions. Since the portion of pipe segment leading to the valve switched OFF and dead spaces of the valve itself are cut off from the flow, stagnation of a certain amount of reagent is unavoidable.

Said drawbacks are overcome by the device for introducing reagents into an organometallic vapour phase deposition apparatus, provided by the present invention as defined in Claim 1, which, comprising an only valve body and no longer requiring pipe segments, presents a considerable reduction in dead spaces, encumbrance and leakage losses through joints; it is submitted to continuous purging in all its internal zones, whether the reagent is sent to the exhaust line or to the reactor, or the flow is halted. The present device can directly replace the pair of valves usually used in a vent/run system.

The present invention provides a device for introducing reagents into an organometallic vapour phase deposition apparatus which has just five ways for routing reagent and carrier gases and two inlets for letting in compressed air to control pneumatic actuators provided for switching flows between different ways.

The foregoing and other characteristics of the present invention will be made clearer by the following description and by the annexed drawing wherein:
- Fig.1 is a perspective view of the device;
- Fig.2 is a partial longitudinal sectional view;
- Fig.3 is a partial longitudinal sectional view, perpendicular to that of Fig.2.

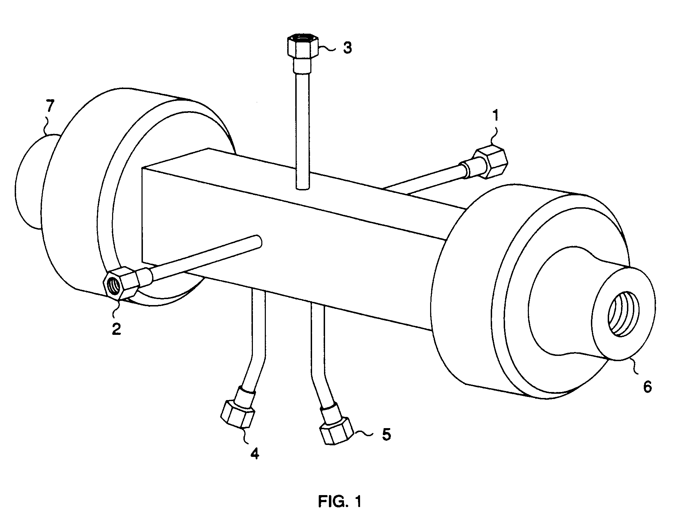

The perspective view of Fig.1 shows the device, comprising a valve body provided with five ways 1,2,3,4 and 5 for reagent and carrier gas transit. Two inlets 6 and 7 allow compressed air to be let in for controlling pneumatic actuators, which switch flows between different ways.

More particularly, the reagent, which can be pure or mixed with carrier gas, is injeced through input way 1.

A carrier gas enters through way 2 and goes out through way 5 without undergoing any control inside the device. Analogously, a carrier gas enters through way 3 and goes out through way 4 without undergoing any control. Ways 3 and 4 can, e.g., be part of the exhaust line and ways 2 and 5 can be part of the line leading to the reactor.

During the usual operation the actuators are activated by compressed air injected through inlets 6 and 7 so as to connect way 1 with the continuous flow traversing ways 2 and 5, thus sending the reagent to the reactor, or so as to put in communication way 1 with continuous flow traversing ways 3 and 4, thus venting the reagent towards the exhaust. When idle, the actuators cut off way 1, so that only the carrier gas flows into the device and the reagent is halted.

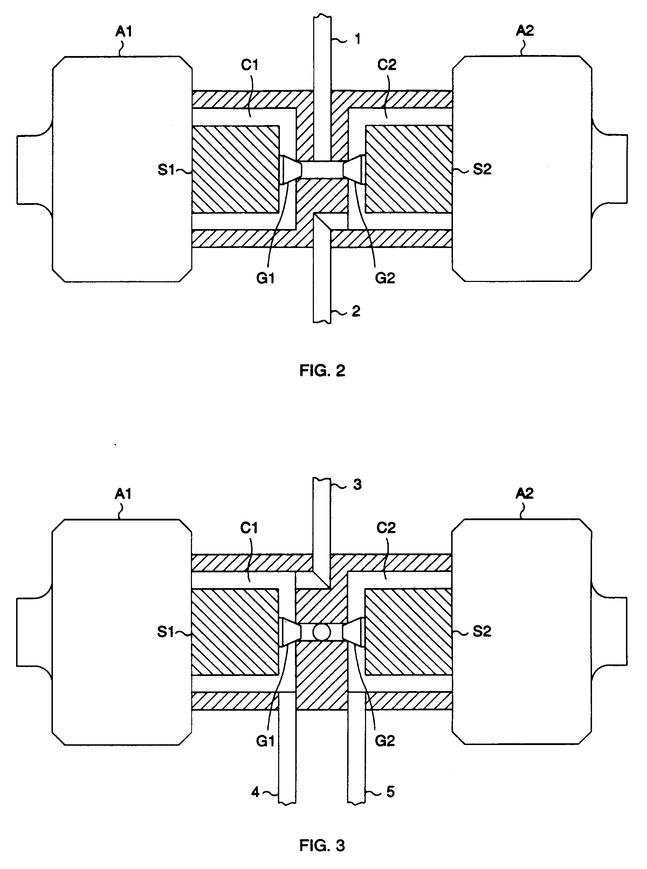

In the sectional view, shown in Fig.2, the internal device structure can be seen, except actuators A1 and A2, which are of a type commercially available. Way 1 ends in the middle of the segment of a perpendicular pipe, generally closed at its ends by two stem tips G1 and G2, drawn to opening position by bellows S1 and S2 belonging to pneumatic actuators A1 and A2. If actuator A2 is activated, stem tip G2 opens and lets the reagent flow from way 1 to chamber C2. This chamber communicates permanently with way 2 and way 5, visible in Fig.3, wherethrough the carrier gas flows. If actuator A1 is activated and actuator A2 is reset, stem tip G1 opens and stem tip G2 closes, so that the reagent flow is diverted towards chamber C1. As this chamber communicates permanently with ways 3 and 4, shown in Fig.3, reagent mixes with the carrier gas flowing therein.

## Claims

1. A device for introducing reagents into an organo-metallic vapour phase deposition apparatus, comprising a first way (1) which is the input way for reagent injection and which comprises stem tips (G1, G2); a second way (2) which allows the injection of a carrier gas outgoing through a third way (5) without any control inside the device; and a fourth way (3) which allows the injection of a carrier gas outgoing through a fifth way (4) without any control inside the device; which device consists of a valve body which just has these five ways (1, 2, 3, 4, 5) for routing reagent and carrier gases and two pneumatic actuators (A1, A2) with inlets (6, 7) for letting in compressed air to control the pneumatic actuators (A1, A2) provided for switching or stopping flows between said different ways.

2. A device as in claim 1, characterized in that said first way (1) ends in the middle of the segment of a pipe perpendicular to the first way (1) and usually closed at its end faces by the first and the second stem tip (G1 and G2), drawn to opening position by the first and the second pneumatic actuator (A1, A2), respectively.

3. A device as in claim 2, characterized in that the ways comprise a first chamber (C1), which permanently communicates with said fourth and fifth ways (3, 4) and which communicates through said first stem tip (G1), when it is opened by said first pneumatic actuator (A1), with said first way (1).

4. A device as in claim 2 or 3, characterized in that the ways comprise a second chamber (C2), which permanently communicates with said second and third ways (2, 5) and which communicates through said second stem tip (G2), when it is opened by said second pneumatic actuator (A2), with said first way (1).

## Patentansprüche

1. Vorrichtung zur Reagenzeinleitung in ein Gerät zur metallorganischen Abscheidung aus der Dampfphase, mit einem ersten Anschluß (1), der der Eingangsanschluß für die Reagenzeinführung ist und Stößelköpfe (G1, G2) enthält; einem zweiten Anschluß (2), der die Einführung eines Trägergases ermöglicht, das ohne jede Steuerung innerhalb der Vorrichtung durch einen dritten Anschluß (5) wieder austritt; und einem vierten Anschluß (3), der die Einführung eines Trägergases ermöglicht, das ohne jede Steuerung innerhalb der Vorrichtung durch einen fünften Anschluß (4) wieder austritt; wobei die Vorrichtung aus einem Ventilkörper besteht, der nur diese fünf Anschlüsse (1, 2, 3, 4, 5) zum Durchleiten von Reagenz und Trägergasen und zwei pneumatische Betätigungsvorrichtungen (A1, A2) mit Eingängen (6, 7) zum Einlassen von Druckluft zur Steuerung der pneumatischen Betätigungsvorrichtungen (A1, A2), die zum Schalten oder Sperren von Strömen zwischen den verschiedenen Anschlüssen vorhanden sind, aufweist.

2. Vorrichtung nach Anspruch 1, dadurch gekennzeichnet, daß der erste Anschluß (1) in der Mitte eines Abschnitts eines zum ersten Anschluß (1) rechtwinkligen Rohrs endet, das im Normalzustand an seinen Endflächen durch den ersten bzw. den zweiten Stößelkopf (G1 und G2) geschlossen ist, der von der ersten bzw. der zweiten pneumatischen Betätigungsvorrichtung (A1, A2) in die Öffnungsstellung gezogen wird.

3. Vorrichtung nach Anspruch 2, dadurch gekennzeichnet, daß die Anschlüsse eine erste Kammer (C1) umfassen, die ständig mit dem vierten und dem fünften Anschluß (3, 4) kommuniziert und die weiterhin über den ersten Stößelkopf (G1), wenn er durch die erste pneumatische Betätigungsvorrichtung (A1) geöffnet ist, mit dem ersten Anschluß (1) kommuniziert.

4. Vorrichtung nach Anspruch 2 oder 3, dadurch gekennzeichnet, daß die Anschlüsse eine zweite Kammer (C2) umfassen, die ständig mit dem zweiten und dem dritten Anschluß (2, 5) kommuniziert und die weiterhin über den zweiten Stößelkopf (G2), wenn er durch die zweite pneumatische Betätigungsvorrichtung (A2) geöffnet ist, mit dem ersten Anschluß (1) kommuniziert.

## Revendications

1. Dispositif d'introduction des réactifs dans une installation de dépôt d'organométalliques en phase vapeur, comprenant une première voie (1) qui constitue la voie d'entrée à travers laquelle le réactif est introduit et qui comprend des joints d'étanchéité (G1, G2), une deuxième voie (2) qui permet l'introduction d'un gaz vecteur sortant à travers une troisième voie (5) sans subir aucun contrôle à l'intérieur du dispositif et une quatrième voie (3) qui permet l'introduction d'un gaz vecteur sortant à travers une cinquième voie (4) sans subir aucun contrôle à l'intérieur du dispositif; ledit dispositif est constitué d'un corps soupape qui est équipé exactement de ces cinq voies (1, 2, 3, 4, 5) pour le passage du réactif et du gaz vecteur et de deux actionneurs pneumatiques (A1, A2) avec raccords (6, 7) pour l'introduction de l'air comprimé capable d'activer les actionneurs pneumatiques (A1, A2) prévus pour commuter ou couper les flux entre les différentes voies.

2. Dispositif selon la revendication 1, caractérisé en ce que ladite première voie (1) se termine dans la partie médiane de la portion d'une conduite perpendiculaire à la première voie (1) et normalement close à ses extrémités par le premier et le second joint d'étanchéité (G1 et G2), amenés en position d'ouverture respectivement par le premier et le second actionneurs pneumatiques (A1, A2).

3. Dispositif selon la revendication 2, caractérisé en ce que les voies comprennent une première chambre (C1), qui communique en permanence avec lesdites quatrième et cinquième voies (3, 4) et qui communique à travers ledit premier joint d'étanchéité (G1), quand il est ouvert par ledit premier actionneur pneumatique (A1), avec ladite première voie (1).

4. Dispositif selon les revendications 2 ou 3, caractérisé en ce que les voies comprennent une seconde chambre (C2), qui communique en permanence avec lesdites deuxième et troisième voies (2, 5) et qui communique à travers ledit second joint d'étanchéité (G2), quand il est ouvert par ledit second actionneur pneumatique (A2), avec ladite première voie (1).
